# EUROPEAN PATENT SPECIFICATION

(11) **EP 3 644 071 B1**
(45) Date of publication and mention of the grant of the patent: **05.06.2024**
(21) Application number: 18837617.2
(22) Date of filing: 26.07.2018
(51) Int. Cl.: G01R 21/06, H05B 6/68, H05B 6/06

(54) **SAMPLING CURRENT PROCESSING CIRCUIT, POWER DETECTION CIRCUIT AND ELECTROMAGNETIC COOKING DEVICE**
ABTASTSTROMVERARBEITUNGSSCHALTUNG, STROMDETEKTIONSSCHALTUNG UND ELEKTROMAGNETISCHES KOCHGERÄT
CIRCUIT DE TRAITEMENT DE COURANT D'ÉCHANTILLONNAGE, CIRCUIT DE DÉTECTION DE PUISSANCE ET DISPOSITIF DE CUISSON ÉLECTROMAGNÉTIQUE

(30) Priority: 26.07.2017 CN 201710622132; 26.07.2017 CN 201720919666 U
(43) Date of publication of application: 29.04.2020
(73) Proprietor: Foshan Shunde Midea Electrical Heating Appliances Manufacturing Co., Ltd., Foshan, Guangdong 528311 (CN)
(72) Inventor: ZHONG, Shigang, Foshan Guangdong 528311 (CN); LI, Xinhe, Foshan Guangdong 528311 (CN); LEI, Jun, Foshan Guangdong 528311 (CN); MA, Baizhong, Foshan Guangdong 528311 (CN); LV, Wencan, Foshan Guangdong 528311 (CN); OU, Guoan, Foshan Guangdong 528311 (CN); LIU, Jinming, Foshan Guangdong 528311 (CN)
(74) Representative: RGTH
(86) International application number: PCT/CN2018/097278
(87) International publication number: WO 2019/020085

(56) References cited:
- CN-A- 101 013 326
- CN-A- 101 437 333
- CN-A- 106 444 890
- CN-U- 204 362 337
- CN-U- 205 481 176
- CN-U- 205 861 763
- CN-U- 205 861 763
- CN-U- 207 081 766
- CN-Y- 200 959 570
- JP-A- H1 073 622
- US-A1- 2011 304 397

## Description

### TECHNICAL FIELD

The present disclosure relates to the technical field of cooking appliances, and in particular, to a circuit for processing a sampled current, a power detection circuit, and an electromagnetic cooking appliance.

### BACKGROUND

In a cooking appliance using electromagnetic heating, an output voltage signal and an output current signal of the electromagnetic heating circuit are usually collected and output to a MCU, and the MCU performs a multiplication operation based on these two signals to obtain an operating power of the electromagnetic cooking appliance. The output voltage can be sampled by dividing the output voltage. The sampling signal of the output current is usually small, and needs to be sent to the amplifier for amplification and then converted by Analog/Digital (A/D) to data that the MCU can recognize. However, the existing amplifier has a strong ability to amplify voltage, but has a weak ability to amplify current. Especially when the output voltage of the electromagnetic heating circuit is discontinuous or low, the output current of the electromagnetic heating circuit is low. As a result, the sampled current signal is reduced accordingly, resulting in a smaller voltage after the sampled current signal is amplified, thus it is difficult to be recognized and detected by the MCU. In addition, the voltage output by the amplifier usually needs to charge the filter capacitor at the output end of the amplifier. This causes the speed of forming a stable voltage by the sampled current signal amplified by the amplifier much slower, which affects the MCU's reading of the sampled current signal represented by the voltage signal, and further prevents the electromagnetic cooking appliance from operating properly.
CN 205 861 763 U discloses a IGBT's current sampling circuit for electromagnetic heating device and a electromagnetic heating device, wherein the current sampling circuit includes: sampling with the sampling unit which generates sampled signal to IGBT's operating current, a amplifying unit is linked with sampling unit, and the amplifying unit setting is in IGBT's driver chip, and the amplifying unit enlarges the processing sample signal.

### SUMMARY

The main objective of the present disclosure is to provide a circuit for processing a sampled current, a power detection circuit, and an electromagnetic cooking appliance, which aims to improve the processing capability of the current sampling signal and enable the electromagnetic cooking appliance to be heated under a wide voltage and low power.

In order to achieve the above objective, the present disclosure provides a circuit as defined in claim 1, for processing a sampled current, applied to an electromagnetic cooking appliance, including: a sampling signal input end for inputting a current sampling signal; an amplifier for performing a primary amplification process on the current sampling signal input from the sampling signal input end; a power source; a switching amplifier circuit for performing a secondary amplification process on the current sampling signal amplified by the amplifier; and a feedback circuit for converting the current sampling signal amplified by the switching amplifier circuit into a voltage signal and outputting the voltage signal.

The sampling signal input end is connected to an input end of the amplifier, an output end of the amplifier is connected to an input end of the switching amplifier circuit, an output end of the switching amplifier circuit is connected to an input end of the feedback circuit, and an output end of the feedback circuit is an output end of the circuit for processing the sampled current.

The switching amplifier circuit includes a transistor, a first capacitor, a second capacitor, and a first resistor;

a base of the transistor is connected to the output end of the amplifier, a collector of the transistor is connected to a first end of the first resistor, and a second end of the first resistor is connected to a power source; and an emitter of the transistor is interconnected with a first end of the first capacitor and a first end of the second capacitor, and a second end of the first capacitor and a second end of the second capacitor are both grounded.

The switching amplifier circuit is a current amplifier circuit.

Optionally, the feedback circuit includes a second resistor; a first end of the second resistor is connected to the emitter of the transistor, and is an output end of the feedback circuit; and a second end of the second resistor is grounded.

Optionally, the output end of the feedback circuit is connected to the output end of the amplifier.

Optionally, the feedback circuit further includes a first diode, an anode of the first diode is connected to a first end of the second resistor, and a cathode of the first diode is an output end of the feedback circuit.

Optionally, the feedback circuit further includes a third resistor, a first end of the third resistor is connected to a first end of the second resistor, and a second end of the third resistor is an output end of the feedback circuit.

The present disclosure further provides a power detection circuit for detecting an operating power of an electromagnetic cooking appliance, including an MCU, a voltage sampling circuit, and the circuit for processing the sampled current as described above.

The MCU includes an A/D conversion module, and the amplifier is integrated in the MCU; he output end of the feedback circuit is connected to the A/D conversion module to output the voltage signal output by the feedback circuit to the MCU; and n output end of the voltage sampling circuit is connected to the MCU.

The present disclosure further provides an electromagnetic cooking appliance, including an electromagnetic heating circuit and the power detection circuit connected to an output end of the electromagnetic heating circuit. An input end of the electromagnetic heating circuit is connected to mains, and an output end of the electromagnetic heating circuit is connected to a coil plate of the electromagnetic cooking appliance to supply power to the coil plate;
an input end of the voltage sampling circuit of the power detection circuit is connected to the output end of the electromagnetic heating circuit to detect an operating voltage of the electromagnetic cooking appliance;
the sampling signal input end of the circuit for processing the sampled current of the power detection circuit is connected to the output end of the electromagnetic heating circuit to detect an operating current of the electromagnetic cooking appliance; and
the MCU is configured to control the electromagnetic heating circuit to output a power at a positive half wave or a negative half wave of one cycle of an input voltage when the input voltage of the electromagnetic heating circuit exceeds a zero point, to control the electromagnetic cooking appliance to output the power intermittently.

In technical solutions of the present disclosure, a switching amplifier circuit is provided, the switching amplifier circuit is used in conjunction with the amplifier so that the sampled current of the operating current of the electromagnetic cooking appliance can be rapidly amplified and fed back to the MCU of the electromagnetic cooking appliance through a feedback circuit. In the related arts, the sampling signal is amplified only by the amplifier, and the amplified voltage is small, and the voltage stabilization speed is slow. However, in the present disclosure, after the current sampling signal is rapidly amplified, it can quickly be stabilized and form a voltage signal that can be effectively detected by the MCU, thereby ensuring that the MCU can normally detect the operating power of the electromagnetic cooking appliance. Even when the input voltage and operating power of the electromagnetic cooking appliance are both low, the sampled current of the operating current of the electromagnetic cooking appliance can be rapidly amplified and detected by the MCU, thereby enabling the electromagnetic cooking appliance to be heated under a wide voltage and low power.

### BRIEF DESCRIPTION OF THE DRAWINGS

In order to more clearly illustrate the embodiments of the present disclosure or the technical solutions in the related art, the drawings used in the embodiments or the related art will be briefly described below. Obviously, the drawings in the following description are only some embodiments of the present disclosure. It will be apparent to those skilled in the art that other figures can be obtained from the structures illustrated in the drawings without the inventive effort.
FIG. 1 is a schematic structural diagram of a connection between a circuit for processing a sampled current and an MCU according to an embodiment of the present disclosure;
FIG. 2 is a schematic structural diagram of a connection between the circuit for processing the sampled current and an MCU according to an alternative to the present disclosure, which does not fall under the scope of the claims;
FIG. 3 is a coordinate diagram of a voltage comparison between the related art and the present disclosure after the sampled current is amplified when the electromagnetic cooking appliance performs continuous power output; and
FIG. 4 is a coordinate diagram of voltage comparison between the related art and the present disclosure after the sampled current is amplified when the electromagnetic cooking appliance performs intermittent power output.

### Description of reference numerals:

**Table 1**

| Label | Name | Label | Name |
|---|---|---|---|
| Is | Sampling signal input end | C1 | First capacitor |
| A1 | Amplifier | C2 | Second capacitor |
| Q1 | Transistor | D1 | First diode |
| R1 | First resistor | 1 | A/D conversion module |
| R2 | Second resistor | | |

The realization of the objective, functional characteristics, advantages of the present disclosure are further described with reference to the accompanying drawings.

### DETAILED DESCRIPTION OF THE EMBODIMENTS

The technical solutions of the embodiments of the present disclosure will be clearly and completely described in the following with reference to the accompanying drawings. It is obvious that the embodiments to be described are only a part rather than all of the embodiments of the present disclosure. All other embodiments obtained by persons skilled in the art based on the embodiments of the present disclosure without creative efforts shall fall within the protection scope of the present disclosure.

It is to be understood that, all of the directional instructions in the embodiments of the present disclosure (such as up, down, left, right, front, rear...) can only be used for explaining relative position relations, moving condition of the elements under a special form (referring to figures), and so on, if the special form changes, the directional instructions changes accordingly.

In addition, the descriptions, such as the "first", the "second" in the embodiment of present disclosure, can only be used for describing the aim of description, and cannot be understood as indicating or suggesting relative importance or impliedly indicating the number of the indicated technical feature. Therefore, the feature indicated by the "first", the "second" can express or impliedly include at least one feature. Besides, the technical solution of each embodiment can be combined with each other, however the technical solution must base on that the ordinary skill in that art can realize the technical solution, when the combination of the technical solutions is contradictory or cannot be realized, it should consider that the combination of the technical solutions does not exist, and is beyond the protection scope of the present disclosure.

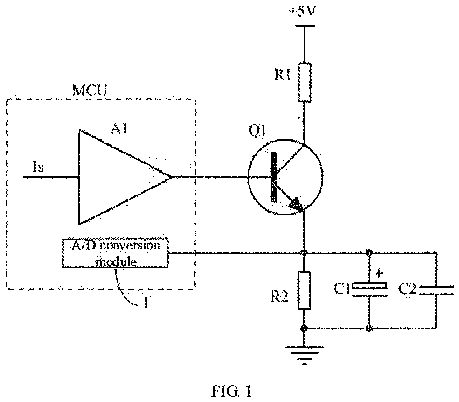

The present disclosure provides a circuit for processing a sampled current, applied to an electromagnetic cooking appliance, such as a rice cooker, an induction cooker, and the like. Specifically, the circuit for processing the sampled current is configured to process a sampled current of an operating current of the electromagnetic cooking appliance. Referring to FIG. 1, the circuit for processing the sampled current includes a sampling signal input end Is for inputting a current sampling signal, an amplifier A1 for performing a primary amplification process on the current sampling signal input from the sampling signal input end, a switching amplifier circuit for performing a secondary amplification process on the current sampling signal amplified by the amplifier A1, and a feedback circuit for converting the current sampling signal amplified by the switching amplifier circuit into a voltage signal and outputting the voltage signal. The sampling signal input end Is is connected to an input end of the amplifier A1, an output end of the amplifier A1 is connected to an input end of the switching amplifier circuit, an output end of the switching amplifier circuit is connected to an input end of the feedback circuit, and an output end of the feedback circuit is an output end of the circuit for processing the sampled current.

The present disclosure further provides a power detection circuit for detecting an operating power of an electromagnetic cooking appliance. The power detection circuit includes an MCU, a voltage sampling circuit, and the circuit for processing the sampled current. The voltage sampling circuit is configured to sample the operating voltage of the electromagnetic cooking appliance, and the circuit for processing the sampled current is configured to sample the operating current of the electromagnetic cooking appliance. The MCU includes an A/D conversion module 1. The amplifier A1 can be set independently of the MCU or integrated in the MCU. An output end of the feedback circuit is connected to the A/D conversion module to output a voltage signal output by the feedback circuit to the MCU. The voltage sampling circuit may use a voltage sensor to sample the operating voltage, or may use a resistor divider circuit to sample the operating voltage, which is not specifically limited herein.

In the present disclosure, the amplifier A1 is configured to perform a primary amplification process on the sampled current of the operating current of the electromagnetic cooking appliance. In order to prevent the voltage signal output by the amplifier A1 from being too small to be detected by the MCU in a timely or effective manner, the switching amplifier circuit is provided. The switching amplifier circuit has stable operating performance and low cost. The switching amplifier circuit utilizes the amplification characteristics of the switch tube when it is turned on, so that the current signal input from the amplifier A1 is further amplified, therefore, the capacitor for filtering can be quickly charged, and a stable voltage signal is input to the MCU through the feedback circuit, thereby ensuring that the MCU can quickly and effectively detect the output voltage of the feedback circuit. It can be understood that the output voltage of the feedback circuit represents the sampled current of the operating current of the electromagnetic cooking appliance, so the technical solution of the present disclosure ensures the normal output of the power of the electromagnetic cooking appliance.

It should be noted here that, since the processing object of the switching amplifier circuit is a current, the switching amplifier circuit is optionally a current amplifier circuit. The current amplifier circuit performs current amplification on a current signal that can be output from the amplifier, so that a better current amplification effect can be obtained. The current amplifier circuit may be a transistor amplifier circuit or a field effect transistor amplifier circuit. In the present disclosure, a transistor amplifier circuit is optionally used. Those skilled in the art can understand that the structure and form of the transistor amplifier circuit can be various; for example, a common base amplifier circuit, a common collector amplifier circuit, and a common emitter amplifier circuit. The advantages of each amplifier circuit are different. In the present disclosure, a common collector amplifier circuit is optionally used. The common collector amplifier circuit has the optimal current amplification effect among the above three types of amplifier circuits; therefore, it is suitable for the purpose of amplifying the current signal in this solution.

In technical solutions of the present disclosure, a switching amplifier circuit is provided, the switching amplifier circuit is used in conjunction with the amplifier so that the sampled current of the operating current of the electromagnetic cooking appliance can be rapidly amplified and fed back to the MCU of the electromagnetic cooking appliance through a feedback circuit. In the related arts, the sampling signal is amplified only by the amplifier, and the amplified voltage is small, and the voltage stabilization speed is slow. However, in the present disclosure, after the current sampling signal is rapidly amplified, it can quickly be stabilized and form a voltage signal that can be effectively detected by the MCU, thereby ensuring that the MCU can normally detect the operating power of the electromagnetic cooking appliance. Even when the input voltage and operating power of the electromagnetic cooking appliance are both low, the sampled current of the operating current of the electromagnetic cooking appliance can be rapidly amplified and detected by the MCU, thereby enabling the electromagnetic cooking appliance to be heated under a wide voltage and low power.

In the present disclosure, the transistor amplifier circuit includes a transistor Q1, a first capacitor C1, a second capacitor C2, and a first resistor R1. A controlled end of the transistor Q1 is connected to the output end of the amplifier A1, a collector of the transistor Q1 is connected to a first end of the first resistor R1, and a second end of the first resistor R1 is connected to a power source. An emitter of the transistor Q1 is interconnected with a first end of the first capacitor C1 and a first end of the second capacitor C2, and a second end of the first capacitor C1 and a second end of the second capacitor C2 are both grounded. The transistor Q1 amplifies the current output from the amplifier A1. The first capacitor C1 and the second capacitor C2 filter the electric signal output from the transistor Q1 to form a DC level. The transistor Q1 is an NPN tube. It can be understood that the transistor Q1 can also be a PNP tube, and the circuit structure will be slightly changed at this time. The power source is a +5V voltage source.

The feedback circuit includes a second resistor R2. A first end of the second resistor R2 is connected to an emitter of the transistor Q1, and is an output end of the feedback circuit. A second end of the second resistor R2 is grounded. The second resistor R2 converts the current output from the emitter of the transistor Q1 into a voltage signal and inputs the voltage signal to the MCU.

As can be seen, since the current output from the transistor Q1 is large, the current is converted into a voltage through the second resistor R2, and the first capacitor C1 and the second capacitor C2 are quickly charged. Further, the influence of the existence of the first capacitor C1 and the second capacitor C2 on the rapid formation of a stable voltage signal of the feedback circuit is greatly reduced, and the MCU can quickly detect the voltage signal fed back by the feedback circuit. The voltage signal reflects the operating current value of the electromagnetic cooking appliance.

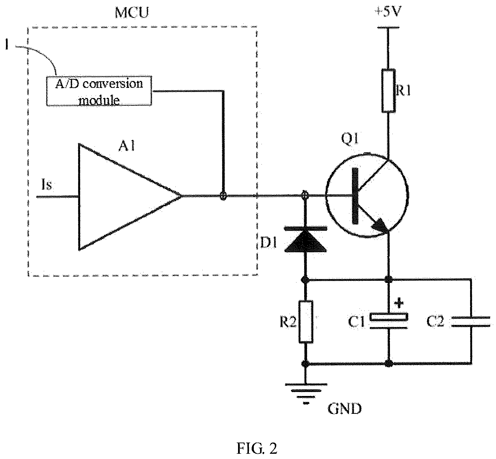

Referring to FIG. 2, as an alternative to the present disclosure, which does not fall into the scope of the claimed invention, the amplifier A1 is optionally a voltage amplifier and is integrated inside the MCU. The voltage amplifier may perform preliminary voltage amplification on the input current sampling signal to improve the driving capability of the current sampling signal amplified by the voltage amplifier to the current amplification circuit. In order to further accelerate the MCU to detect the voltage value output by the feedback circuit, to realize the real-time performance of the MCU detecting the operating current signal of the cooking appliance, therefore, the output end of the feedback circuit is provided to be connected to the output end of the amplifier A1. That is, the electric signal output by the amplifier A1 passes through the switching amplifier circuit and the feedback circuit to form a DC voltage, and then is fed back to the output end of the amplifier A1 to form a closed loop circuit. The output end of the amplifier A1 is one of the pins of the MCU. The output end of the amplifier A1 is connected to the A/D conversion module 1 inside the MCU to convert the voltage signal fed back by the feedback circuit into a digital signal.

When the output end of the feedback circuit is connected to the output end of the amplifier A1, it is provided that the feedback circuit further includes a first diode D1, an anode of the first diode D1 is connected to a first end of the second resistor R2, and the cathode of the first diode D1 is an output end of the feedback circuit. This embodiment uses the unidirectional conductivity of the diode, so that the first diode D1 is configured to feed back the voltage value formed by the second resistor R2 to the output end of the amplifier A1.

In another embodiment, the feedback circuit further includes a third resistor (not shown), a first end of the third resistor is connected to a first end of the second resistor R2, and a second end of the third resistor is an output end of the feedback circuit. In this embodiment, the third resistor is configured to feed back the voltage value formed by the second resistor R2 to the output end of the amplifier A1.

The present disclosure further provides an electromagnetic cooking appliance. The electromagnetic cooking appliance includes an electromagnetic heating circuit, and the power detection circuit connected to an output end of the electromagnetic heating circuit. Since the electromagnetic cooking appliance adopts all the technical solutions of all the above embodiments, it has at least all the beneficial effects brought by the technical solutions of the above embodiments, which will not be described in detail here. An input end of the electromagnetic heating circuit is connected to mains, and an output end of the electromagnetic heating circuit is connected to a coil plate of the electromagnetic cooking appliance to supply power to the coil plate. The power detection circuit is configured to collect the output voltage and output current of the electromagnetic heating circuit to obtain the output power of the electromagnetic heating circuit, that is, the operating power of the electromagnetic cooking appliance.

The MCU is configured to control the electromagnetic heating circuit to output a power at a positive half wave or a negative half wave of one cycle of an input voltage when the input voltage of the electromagnetic heating circuit exceeds a zero point, to control the electromagnetic cooking appliance to output the power intermittently.

Specially, when the input voltage of the electromagnetic heating circuit exceeds a zero point, controlling whether the electromagnetic heating circuit to output a power at a next positive half wave or a next negative half wave, to control the average operating power of the electromagnetic cooking appliance in one cycle. In order to facilitate the distinguishing, it is set here that the input voltage of the electromagnetic heating circuit keeps operating in all its cycles as the continuous power output operating mode, and the operating mode of stopping the output power at the next positive half wave or the next negative half wave when the input voltage of the electromagnetic heating circuit exceeds the zero point is set to the intermittent power output operating mode. In the intermittent power output mode, the cycle of the input voltage of the electromagnetic heating circuit is used as a reference, the output power of the electromagnetic cooking appliance is controlled during the first half of the input voltage, and the electromagnetic cooking appliance is controlled to stop outputting power during the second half of the input voltage.

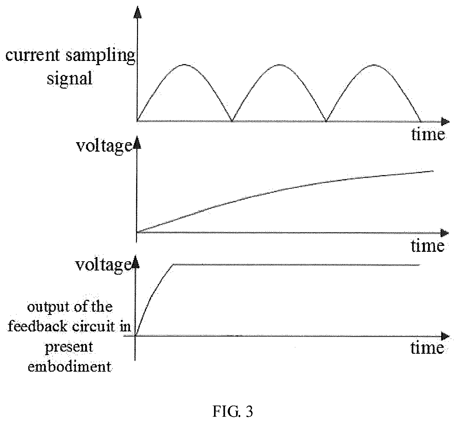

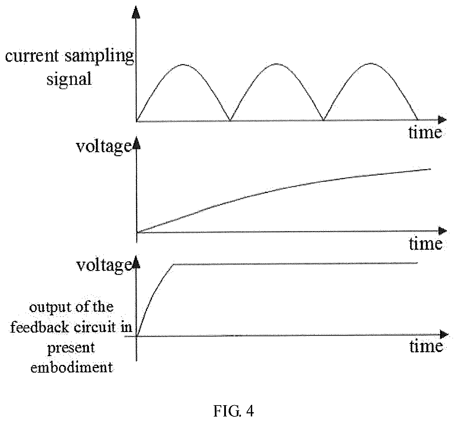

Referring to FIG. 3 and FIG. 4, those skilled in the art can understand that since the electromagnetic heating circuit inputs AC power, the frequency is 50Hz. Therefore, the output power of the electromagnetic cooking appliance in this solution also has a fixed cycle. Assume that the electromagnetic cooking appliance outputs 1000W in one cycle, when the intermittent power output mode is used, since the output power will be stopped for one cycle after one cycle of output power, the total output power is 1000W in two cycles; further, it is concluded that the electromagnetic cooking appliance achieves an average output of 500W in each cycle. The intermittent power output method enables the electromagnetic cooking appliance to achieve average low-power heating.

In the related arts, when the intermittent power output operating mode is adopted, the sampled current value of the output current of the electromagnetic heating circuit is small, which makes it difficult for the MCU to detect the sampled current, and thus the normal output of power cannot be achieved. Since the technical solution of the present disclosure improves the circuit for processing the sampled current, the MCU can detect the smaller current sampling signal. Furthermore, the electromagnetic cooking appliance can flexibly control the output power of the electromagnetic cooking appliance through the intermittent power output operating mode and the continuous power output operating mode.

The above are only preferred embodiments of the present disclosure, and thus do not limit the scope of the present disclosure, which is defined by the appended claims.

## Claims

1. A circuit for processing a sampled current, applied to an electromagnetic cooking appliance, comprising:
a sampling signal input end (Is) for inputting a current sampling signal;
an amplifier (A1) for performing a primary amplification on the current sampling signal inputted from the sampling signal input end (Is);
a power source;
**characterized by**
a switching amplifier circuit for performing a secondary amplification on the current sampling signal amplified by the amplifier (A1); and
a feedback circuit for converting the current sampling signal amplified by the switching amplifier circuit into a voltage signal and outputting the voltage signal;
wherein the sampling signal input end (Is) is connected to an input end of the amplifier (A1), an output end of the amplifier (A1) is connected to an input end of the switching amplifier circuit, an output end of the switching amplifier circuit is connected to an input end of the feedback circuit, and an output end of the feedback circuit is an output end of the circuit for processing the sampled current,
wherein:
the switching amplifier circuit comprises a transistor (Q1), a first capacitor (C1), a second capacitor (C2), and a first resistor (R1);
a base of the transistor (Q1) is connected to the output end of the amplifier (A1), a collector of the transistor (Q1) is connected to a first end of the first resistor (R1), and a second end of the first resistor (R1) is connected to the power source; and
an emitter of the transistor (Q1) is interconnected with a first end of the first capacitor (C1) and a first end of the second capacitor (C2), and a second end of the first capacitor (C1) and a second end of the second capacitor (C2) are both grounded;
wherein the switching amplifier circuit is a current amplifier circuit.

2. The circuit according to claim 1, wherein:
the feedback circuit comprises a second resistor (R2);
a first end of the second resistor (R2) is connected to the emitter of the transistor (Q1), and the first end of the second resistor (R2) is an output end of the feedback circuit; and
a second end of the second resistor (R2) is grounded.

3. The circuit according to claim 1 or 2, wherein the output end of the feedback circuit is connected to the output end of the amplifier (A1).

4. The circuit according to claim 3, wherein the feedback circuit further comprises a first diode (D1), an anode of the first diode (D1) is connected to the first end of the second resistor (R2), and a cathode of the first diode (D1) is an output end of the feedback circuit.

5. The circuit according to claim 3, wherein the feedback circuit further comprises a third resistor, a first end of the third resistor is connected to the first end of the second resistor (R2), and a second end of the third resistor is an output end of the feedback circuit.

6. A power detection circuit for detecting an operating power of an electromagnetic cooking appliance, comprising a microcontroller (MCU), a voltage sampling circuit, and the circuit for processing the sampled current as recited in any one of claims 1 to 5, wherein:
the MCU comprises an A/D conversion module (1), and the amplifier (A1) is integrated in the MCU;
the output end of the feedback circuit is connected to the A/D conversion module (1) to output the voltage signal to the MCU; and
an output end of the voltage sampling circuit is connected to the MCU.

7. An electromagnetic cooking appliance, comprising an electromagnetic heating circuit and the power detection circuit as recited in claim 6 and connected to an output end of the electromagnetic heating circuit, wherein:
an input end of the electromagnetic heating circuit is connected to mains electricity, and the output end of the electromagnetic heating circuit is connected to a coil plate of the electromagnetic cooking appliance to supply electricity to the coil plate;
an input end of the voltage sampling circuit of the power detection circuit is connected to the output end of the electromagnetic heating circuit to detect an operating voltage of the electromagnetic cooking appliance;
the sampling signal input end (Is) of the circuit for processing the sampled current of the power detection circuit is connected to the output end of the electromagnetic heating circuit to detect an operating current of the electromagnetic cooking appliance; and
the MCU is configured to control the electromagnetic heating circuit to output a power during a positive half wave cycle or a negative half wave cycle of an input voltage of the electromagnetic heating circuit when the input voltage of the electromagnetic heating circuit exceeds a zero point, so as to control the electromagnetic cooking appliance to output the power intermittently.

## Patentansprüche

1. Schaltung zur Verarbeitung eines abgetasteten Stroms, der an ein elektromagnetisches Kochgerät angelegt wird, umfassend:
ein Abtastsignaleingangsende (Is) zur Eingabe eines Stromabtastsignals;
einen Verstärker (A1) zur Durchführung einer primären Verstärkung des Stromabtastsignals, das von dem Abtastsignaleingangsende (Is) eingegeben wird;
eine Stromquelle;
**gekennzeichnet durch**
eine Schaltverstärkerschaltung zur Durchführung einer Sekundärverstärkung des durch den Verstärker (A1) verstärkten Stromabtastsignals; und
eine Rückkopplungsschaltung zum Umwandeln des durch die Schaltverstärkerschaltung verstärkten Stromabtastsignals in ein Spannungssignal und zum Ausgeben des Spannungssignals;
wobei das Abtastsignaleingangsende (Is) mit einem Eingangsende des Verstärkers (A1) verbunden ist, ein Ausgangsende des Verstärkers (A1) mit einem Eingangsende der Schaltverstärkerschaltung verbunden ist, ein Ausgangsende der Schaltverstärkerschaltung mit einem Eingangsende der Rückkopplungsschaltung verbunden ist und ein Ausgangsende der Rückkopplungsschaltung ein Ausgangsende der Schaltung zur Verarbeitung des abgetasteten Stroms ist,
wobei:
die Schaltverstärkerschaltung einen Transistor (Q1), einen ersten Kondensator (C1), einen zweiten Kondensator (C2) und einen ersten Widerstand (R1) umfasst;
eine Basis des Transistors (Q1) mit dem Ausgangsende des Verstärkers (A1) verbunden ist, ein Kollektor des Transistors (Q1) mit einem ersten Ende des ersten Widerstands (R1) verbunden ist, und ein zweites Ende des ersten Widerstands (R1) mit der Stromquelle verbunden ist; und
ein Emitter des Transistors (Q1) mit einem ersten Ende des ersten Kondensators (C1) und einem ersten Ende des zweiten Kondensators (C2) verbunden ist, und ein zweites Ende des ersten Kondensators (C1) und ein zweites Ende des zweiten Kondensators (C2) beide geerdet sind;
wobei die Schaltverstärkerschaltung eine Stromverstärkerschaltung ist.

2. Schaltung gemäß Anspruch 1, wobei:
die Rückkopplungsschaltung einen zweiten Widerstand (R2) umfasst;
ein erstes Ende des zweiten Widerstands (R2) mit dem Emitter des Transistors (Q1) verbunden ist, und das erste Ende des zweiten Widerstands (R2) ein Ausgangsende der Rückkopplungsschaltung ist; und
ein zweites Ende des zweiten Widerstands (R2) geerdet ist.

3. Schaltung gemäß Anspruch 1 oder 2, wobei das Ausgangsende der Rückkopplungsschaltung mit dem Ausgangsende des Verstärkers (A1) verbunden ist.

4. Schaltung gemäß Anspruch 3, wobei die Rückkopplungsschaltung ferner eine erste Diode (D1) umfasst, eine Anode der ersten Diode (D1) mit dem ersten Ende des zweiten Widerstands (R2) verbunden ist und eine Kathode der ersten Diode (D1) ein Ausgangsende der Rückkopplungsschaltung ist.

5. Schaltung gemäß Anspruch 3, wobei die Rückkopplungsschaltung ferner einen dritten Widerstand umfasst, ein erstes Ende des dritten Widerstands mit dem ersten Ende des zweiten Widerstands (R2) verbunden ist und ein zweites Ende des dritten Widerstands ein Ausgangsende der Rückkopplungsschaltung ist.

6. Leistungserfassungsschaltung zum Erfassen einer Betriebsleistung eines elektromagnetischen Kochgeräts, umfassend einen Mikrocontroller (MCU), eine Spannungsabtastschaltung und die Schaltung zum Verarbeiten des abgetasteten Stroms nach einem der Ansprüche 1 bis 5, wobei:
der MCU ein A/D-Wandlermodul (1) umfasst, und der Verstärker (A1) in den MCU integriert ist;
das Ausgangsende der Rückkopplungsschaltung mit dem A/D-Wandlermodul (1) verbunden ist, um das Spannungssignal an den MCU auszugeben; und
ein Ausgang der Spannungsabtastschaltung mit dem MCU verbunden ist.

7. Elektromagnetisches Kochgerät, das eine elektromagnetische Heizschaltung und die in Anspruch 6 genannte Leistungserfassungsschaltung umfasst und mit einem Ausgangsende der elektromagnetischen Heizschaltung verbunden ist, wobei:
ein Eingangsende der elektromagnetischen Heizschaltung mit dem Stromnetz verbunden ist, und das Ausgangsende der elektromagnetischen Heizschaltung mit einer Spulenplatte des elektromagnetischen Kochgeräts verbunden ist, um die Spulenplatte mit Strom zu versorgen;
ein Eingangsende der Spannungsabtastschaltung der Leistungserfassungsschaltung mit dem Ausgangsende der elektromagnetischen Heizschaltung verbunden ist, um eine Betriebsspannung des elektromagnetischen Kochgeräts zu erfassen;
das Abtastsignaleingangsende (Is) der Schaltung zur Verarbeitung des abgetasteten Stroms der Leistungserfassungsschaltung mit dem Ausgangsende der elektromagnetischen Heizschaltung verbunden ist, um einen Betriebsstrom des elektromagnetischen Kochgeräts zu erfassen; und
der MCU so konfiguriert ist, dass er die elektromagnetische Heizschaltung so steuert, dass er während eines positiven Halbwellenzyklus oder eines negativen Halbwellenzyklus einer Eingangsspannung der elektromagnetischen Heizschaltung eine Leistung abgibt, wenn die Eingangsspannung der elektromagnetischen Heizschaltung einen Nullpunkt überschreitet, um das elektromagnetische Kochgerät so zu steuern, dass es die Leistung intermittierend abgibt.

## Revendications

1. Circuit de traitement d'un courant échantillonné, appliqué à un appareil de cuisson électromagnétique, comprenant :
une extrémité d'entrée du signal d'échantillonnage (Is) pour l'entrée d'un signal d'échantillonnage actuel ;
un amplificateur (A1) pour effectuer une amplification primaire sur le signal d'échantillonnage actuel provenant de l'extrémité d'entrée du signal d'échantillonnage (Is) ;
une source d'énergie ;
**caractérisé par**
un circuit amplificateur de commutation pour effectuer une amplification secondaire sur le signal d'échantillonnage de courant amplifié par l'amplificateur (A1) ; et
un circuit de rétroaction pour convertir le signal d'échantillonnage de courant amplifié par le circuit amplificateur de commutation en un signal de tension et pour émettre le signal de tension ;
dans lequel l'extrémité d'entrée du signal d'échantillonnage (Is) est connectée à une extrémité d'entrée de l'amplificateur (A1), une extrémité de sortie de l'amplificateur (A1) est connectée à une extrémité d'entrée du circuit amplificateur de commutation, une extrémité de sortie du circuit amplificateur de commutation est connectée à une extrémité d'entrée du circuit de rétroaction, et une extrémité de sortie du circuit de rétroaction est une extrémité de sortie du circuit pour le traitement du courant échantillonné,
dans lequel :
le circuit amplificateur de commutation comprend un transistor (Q1), un premier condensateur (C1), un second condensateur (C2) et une première résistance (R1) ;
une base du transistor (Q1) est connectée à l'extrémité de sortie de l'amplificateur (A1), un collecteur du transistor (Q1) est connecté à une première extrémité de la première résistance (R1), et une deuxième extrémité de la première résistance (R1) est connectée à la source d'alimentation ; et
un émetteur du transistor (Q1) est interconnecté avec une première extrémité du premier condensateur (C1) et une première extrémité du second condensateur (C2), et une seconde extrémité du premier condensateur (C1) et une seconde extrémité du second condensateur (C2) sont toutes deux mises à la terre ;
dans lequel le circuit amplificateur de commutation est un circuit amplificateur de courant.

2. Le circuit selon la revendication 1, dans lequel :
le circuit de rétroaction comprend une deuxième résistance (R2) ;
une première extrémité de la seconde résistance (R2) est connectée à l'émetteur du transistor (Q1), et la première extrémité de la seconde résistance (R2) est une extrémité de sortie du circuit de rétroaction ; et
une deuxième extrémité de la deuxième résistance (R2) est mise à la terre.

3. Le circuit selon la revendication 1 ou 2, dans lequel l'extrémité de sortie du circuit de rétroaction est connectée à l'extrémité de sortie de l'amplificateur (A1).

4. Circuit selon la revendication 3, dans lequel le circuit de rétroaction comprend en outre une première diode (D1), une anode de la première diode (D1) est connectée à la première extrémité de la deuxième résistance (R2), et une cathode de la première diode (D1) est une extrémité de sortie du circuit de rétroaction.

5. Circuit selon la revendication 3, dans lequel le circuit de rétroaction comprend en outre une troisième résistance, une première extrémité de la troisième résistance est connectée à la première extrémité de la deuxième résistance (R2), et une deuxième extrémité de la troisième résistance est une extrémité de sortie du circuit de rétroaction.

6. Circuit de détection de puissance pour détecter une puissance de fonctionnement d'un appareil de cuisson électromagnétique, comprenant un microcontrôleur (MCU), un circuit d'échantillonnage de tension, et le circuit de traitement du courant échantillonné tel que décrit dans l'une des revendications 1 à 5, dans lequel :
le MCU comprend un module de conversion A/N (1), et l'amplificateur (A1) est intégré dans le MCU;
l'extrémité de sortie du circuit de rétroaction est connectée au module de conversion A/N (1) pour délivrer le signal de tension à l'unité MCU ; et
une extrémité de sortie du circuit d'échantillonnage de la tension est connectée à l'unité MCU.

7. Appareil de cuisson électromagnétique, comprenant un circuit de chauffage électromagnétique et le circuit de détection de puissance tel que décrit dans la revendication 6 et connecté à une extrémité de sortie du circuit de chauffage électromagnétique, dans lequel :
une extrémité d'entrée du circuit de chauffage électromagnétique est connectée au réseau électrique, et l'extrémité de sortie du circuit de chauffage électromagnétique est connectée à une plaque de bobine de l'appareil de cuisson électromagnétique pour fournir de l'électricité à la plaque de bobine ;
une extrémité d'entrée du circuit d'échantillonnage de tension du circuit de détection de puissance est connectée à l'extrémité de sortie du circuit de chauffage électromagnétique pour détecter une tension de fonctionnement de l'appareil de cuisson électromagnétique ;
l'extrémité d'entrée du signal d'échantillonnage (Is) du circuit de traitement du courant échantillonné du circuit de détection de puissance est connectée à l'extrémité de sortie du circuit de chauffage électromagnétique pour détecter un courant de fonctionnement de l'appareil de cuisson électromagnétique ; et
l'unité MCU est configurée pour contrôler le circuit de chauffage électromagnétique afin de fournir une puissance pendant un demi-cycle d'onde positif ou un demi-cycle d'onde négatif d'une tension d'entrée du circuit de chauffage électromagnétique lorsque la tension d'entrée du circuit de chauffage électromagnétique dépasse un point zéro, de manière à contrôler l'appareil de cuisson électromagnétique afin qu'il fournisse une puissance de manière intermittente.
